# DEMANDE DE BREVET EUROPEEN

(11) **EP 4 506 991 A1**
(43) Date de publication de la demande: **12.02.2025**
(21) Numéro de dépôt: 24193483.5
(22) Date de dépôt: 08.08.2024
(51) Int. Cl.: H01L 21/8256, H01L 27/088, H01L 29/775, H01L 29/24, H01L 29/06, H01L 21/8234

(54) **PROCÉDÉ DE RÉALISATION D'UN DISPOSITIF MICROÉLECTRONIQUE À BASE D'UN MATÉRIAU SEMI-MÉTALLIQUE**

(30) Priorité: 11.08.2023 FR 2308687
(71) Demandeur: Commissariat à l'Energie Atomique et aux Energies Alternatives, 75015 Paris (FR)
(72) Inventeur: BARRAUD, SYLVAIN, 38054 GRENOBLE CEDEX 09 (FR)
(74) Mandataire: Hautier IP

(57) **Abrégé**

L'invention concerne un dispositif comprenant un transistor (T1, T2) comprenant :
• une source (42) et un drain (43),
• une pluralité de canaux (41a, 41b, 41c) à base d'un matériau semi-métallique,
• une grille (50) enrobante entourant les canaux (41a, 41b, 41c),
• une couche diélectrique de grille (30) séparant chaque canal (41a, 41b, 41c) et la grille (50) enrobante,
• des contacts (40S, 40D) de source et de drain à base du matériau semi-métallique.

La grille (50) enrobante entoure totalement un ou plusieurs canaux (41a, 41b, 41c), selon une architecture GAA.

L'invention concerne également un procédé de réalisation d'un tel dispositif.

## Description

### DOMAINE TECHNIQUE

La présente invention se rapporte au domaine des technologies de la microélectronique. Elle trouve pour application particulièrement avantageuse la fabrication de dispositifs avancés de type FET (« Field-Effect Transistor » en anglais, ou transistor à effet de champ) dont les canaux de conduction sont à base d'un matériau semi-métallique.

### ETAT DE LA TECHNIQUE

Pour répondre aux exigences croissantes sur les performances des dispositifs microélectroniques et leur miniaturisation, l'emploi de matériaux autre que le silicium est désormais envisagé pour la fabrication des transistors. Un exemple de matériaux intégrés récemment dans les transistors est le bismuth, un matériau semi-métallique. À l'état massif, un matériau semi-métallique présente des propriétés électriques similaires à celles d'un matériau métallique. En revanche, lorsque le matériau semi-métallique est structuré de façon à présenter des dimensions nanométriques, ce matériau adopte un comportement électrique similaire à celui d'un semi-conducteur. Ceci est notamment dû à un effet de confinement quantique.

Le document « Semimetal to semiconductor transition and polymer electrolyte gate modulation in single-crystalline bismuth nanowires, Jeongmin Kim and Wooyoung Lee, Nanoscale, 2 (2017) » divulgue un dispositif à base de nanofils de bismuth. Dans ce procédé, les nanofils de bismuth sont initialement synthétisés sur un substrat de bismuth, puis détachés de leur support et manipulés individuellement en vue de la conception de canaux d'un transistor à effet de champ. Bien que ce dispositif démontre des performances prometteuses, son procédé de fabrication ne permet pas son industrialisation ni sa production à grande échelle.

Le document US2018/0190799 A1 divulgue un autre procédé de fabrication intégrant un matériau semi-métallique dans un transistor à grille enrobante. Un agencement vertical des canaux est divulgué dans ce document. Une couche semi-métallique à base de bismuth est déposée dans des trous ayant des dimensions nanométriques pour former les canaux semi-conducteurs sous forme de nanofils verticaux. La couche semi-métallique débouche des trous pour former des régions de source ou de drain. Ces régions de source/drain présentent des dimensions plus grandes que celles des canaux, et présentent un caractère métallique. Un tel procédé exploitant la transition semi-métal/semi-conducteur par constriction géométrique est adapté à une exploitation industrielle. La formation des trous ayant des dimensions nanométriques est difficile à maîtriser. Les densités d'intégration accessibles par ce procédé restent limitées.

Le document FR3095549 divulgue un autre procédé de réalisation d'un transistor à base d'un matériau semi-métallique selon un agencement planaire. La réalisation d'une telle architecture est plus simple et plus fiable. Un "moule" définissant les motifs destinés à former les canaux et les régions de source et de drain et leurs contacts, est ici préalablement réalisé. Le matériau semi-métallique est ensuite déposé dans ce moule, puis aminci par polissage. Cela permet d'obtenir plus facilement des dimensions conférant aux canaux un caractère semi-conducteur. Là encore, la densité d'intégration reste limitée. Le contrôle électrostatique des transistors est également limité.

La présente invention propose de pallier au moins en partie les inconvénients des procédés et architectures connus. En particulier, un objectif de la présente invention est de proposer un dispositif permettant d'augmenter la densité d'intégration de transistors à base d'un matériau semi-métallique. Un autre objectif de la présente invention est de proposer un procédé de fabrication d'un tel dispositif.

### RESUME

Pour atteindre cet objectif, selon un mode de réalisation on prévoit un dispositif microélectronique comprenant au moins un transistor comprenant :
- une source et un drain,
- une pluralité de canaux à base d'un matériau semi-métallique, lesdits canaux s'étendant selon une direction longitudinale x entre la source et le drain, chaque canal présentant au moins une dimension transverse, prise perpendiculairement à la direction longitudinale x, telle que le matériau semi-métallique présente une propriété de conduction électrique d'un matériau semiconducteur,
- une grille dite enrobante, entourant au moins un des canaux, et de préférence plusieurs canaux de la pluralité de canaux,
- une couche diélectrique de grille séparant chaque canal et la grille enrobante,
- des contacts de source et de drain connectés respectivement à la source et au drain, l'un au moins parmi les contacts de source et de drain étant à base du matériau semi-métallique et présentant des dimensions telles que le matériau semi-métallique présente une propriété de conduction électrique d'un matériau métallique,
- des espaceurs de part et d'autre de la grille, configurés pour isoler électriquement la grille vis-à-vis des contacts de source et de drain.

Avantageusement, la grille enrobante entoure totalement au moins un des canaux, et de préférence plusieurs canaux de la pluralité de canaux, dans un plan transverse yz perpendiculaire à la direction longitudinale x.

Une telle architecture à grille enrobante est dite GAA (acronyme de Gate All Around), et comprend des canaux empilés les uns sur les autres selon une direction dite verticale z, entourés par une grille commune. Cela permet avantageusement d'améliorer le contrôle électrostatique des transistors et d'obtenir une plus forte densité de courant par unité de surface. Par ailleurs, une telle architecture permet une forte densité d'intégration des transistors. En particulier, le dispositif peut comprendre au moins deux transistors adjacents selon une direction horizontale, chaque transistor comprenant des canaux empilés selon la direction verticale z.

Une telle architecture de dispositif dépasse avantageusement les performances des architectures connues de transistor à base d'un matériau semi-métallique.

Un autre aspect de l'invention concerne un procédé de fabrication d'un tel dispositif microélectronique, comprenant les étapes suivantes :
- Fournir sur un substrat un empilement comprenant selon la direction z une pluralité de premières couches en un premier matériau, alternées avec une pluralité de deuxièmes couches en un deuxième matériau, le premier matériau et le deuxième matériau étant différents entre eux et différents du matériau semi-métallique formant les canaux,
- Former dans cet empilement des premières ouvertures définissant des premiers motifs,
- Former une grille sacrificielle à cheval sur les premiers motifs et en partie dans les premières ouvertures,
- Former dans les premiers motifs des deuxièmes ouvertures définissant des deuxièmes motifs, tels que les deuxièmes motifs soient transverses aux premiers motifs,
- Former la couche diélectrique de grille,
- Former les espaceurs,
- Former une couche de maintien dans lesdites deuxièmes ouvertures sur des flancs exposés des deuxièmes motifs,
- Retirer la grille sacrificielle de sorte à former des troisièmes ouvertures,
- Retirer totalement, à partir des troisièmes ouvertures, le premier matériau des premières couches sélectivement au deuxième matériau des deuxièmes couches, de sorte à former des cavités,
- Remplir par un matériau de grille les cavités, de façon à former la grille enrobante,
- Retirer au moins en partie la couche de maintien de façon à reformer au moins en partie les deuxièmes ouvertures exposant des flancs des deuxièmes couches,
- Retirer totalement, à partir des deuxièmes ouvertures, le deuxième matériau des deuxièmes couches de sorte à former des deuxièmes espaces,
- Déposer une couche à base d'un matériau semi-métallique dans les deuxièmes espaces et au moins en partie dans les deuxièmes ouvertures, de sorte à former simultanément :
   ∘ des canaux à base du matériau semi-métallique à l'aplomb de la grille enrobante,
   ∘ au moins l'un parmi les contacts de source et de drain à base du matériau semi-métallique.

Un principe du procédé selon l'invention consiste à remplacer sélectivement certaines couches de l'empilement initial par le matériau semi-métallique afin de former les canaux du transistor. Le dépôt du matériau semi-métallique forme avantageusement en une seule étape les canaux et au moins l'un des contacts de drain ou de source. L'empilement initial ne comprend pas le matériau semi-métallique. Le dépôt ultérieur du matériau semi-métallique vise à mieux préserver le matériau semi-métallique.

Ainsi, les couches de matériau semi-métallique sont introduites en fin de procédé, après structuration de l'empilement et typiquement après la formation des espaceurs et de la grille enrobante. Cela permet avantageusement de limiter le risque de dégradation du matériau semi-métallique au cours du procédé. Le matériau semi-métallique n'est pas exposé à toutes les étapes du procédé de fabrication. Le matériau semi-métallique est ainsi préservé.

En outre, l'introduction tardive du matériau semi-métallique au cours du procédé de fabrication permet d'utiliser les technologies standard de la microélectronique pour la formation et la structuration de l'empilement. Il n'est pas nécessaire de modifier ou d'adapter les étapes technologiques standard de structuration aux contraintes d'utilisation du matériau semi-métallique. Les coûts du procédé sont ainsi avantageusement limités. Le procédé peut en outre être plus facilement implémenté dans des lignes de production existantes.

Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

Les figures nA (n=1 ... 15) illustrent schématiquement selon des coupes transverses xz des étapes de fabrication d'un dispositif à transistors GAA, selon un premier mode de réalisation de la présente invention.
Les figures nB (n=1...15) illustrent schématiquement selon des coupes transverses yz indiquées sur les figures nA correspondantes, les mêmes étapes de fabrication du dispositif que celles représentées dans les figures nA (n=1...15) respectivement.

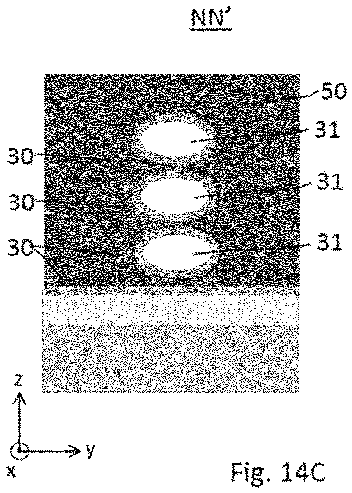

La figure 14C illustre une variante de réalisation quant à la forme des canaux des transistors du dispositif selon l'invention.
Les figures nA (n=16...20) illustrent schématiquement selon des coupes transverses xz des étapes de fabrication d'un dispositif à transistors GAA, selon un deuxième mode de réalisation de la présente invention.
Les figures nB (n=16...20) illustrent schématiquement selon des coupes transverses yz indiquées sur les figures nA correspondantes, les mêmes étapes de fabrication du dispositif que celles représentées dans les figures nA (n=16...20) respectivement.

Sur les figures en coupes transverses, des plans de coupe sont indiqués (A-A', B-B', ..., T-T') avec des références croisées aux plans de coupe des figures correspondantes. Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif comprend au moins deux transistors disposés selon une première direction x ou y dite horizontale, et les canaux de chaque transistor sont empilés selon une deuxième direction z dite verticale, perpendiculaire à la première direction x ou y.

Selon un exemple, l'un parmi les contacts de source et de drain est à base du matériau semi-métallique et l'autre parmi les contacts de source et de drain est à base d'un métal.

Selon un exemple, le matériau semi-métallique est à base d'au moins un élément parmi le bismuth (Bi), l'étain (Sn), antimoine (Sb), arsenic (As).

Selon un exemple, la formation des espaceurs comprend les étapes suivantes :
- Former des premiers espaceurs bordant la grille sacrificielle et prenant appui sur les premiers motifs,
- Avant la formation de la couche de maintien, retirer partiellement, à partir des deuxièmes ouvertures, le premier matériau des premières couches sélectivement au deuxième matériau des deuxièmes couches, de sorte à former des premiers espaces à l'aplomb des premiers espaceurs,
- Remplir les premiers espaces par un premier matériau diélectrique pour former des espaceurs internes.

Selon un exemple, les premiers motifs s'étendent principalement selon la direction longitudinale x, et les deuxièmes motifs s'étendent principalement selon une direction transverse y.

Selon un exemple, la grille enrobante est formée avant le dépôt de la couche à base du matériau semi-métallique. Cela correspond à un procédé de type « gate first » (le remplacement de la grille sacrificielle par une grille fonctionnelle se fait avant la formation des canaux des transistors).

Selon un exemple, la formation de la couche diélectrique de grille est formée après retrait total du premier matériau des premières couches et avant formation de la grille enrobante, par dépôt d'une couche diélectrique dans les cavités et dans les troisièmes ouvertures, sur les parties exposées des deuxièmes couches.

Selon un exemple, la formation des espaceurs et la formation de la couche diélectrique de grille sont effectuées au moins en partie par un même dépôt d'une couche diélectrique dans les cavités. Cela permet de réduire le nombre d'étapes du procédé et/ou d'épaissir les espaceurs.

Selon un exemple, le dépôt de la couche à base du matériau semi-métallique est effectué dans les deuxièmes espaces et dans toutes les deuxièmes ouvertures de sorte à former les canaux et tous les contacts de source et de drain. Le nombre d'étapes du procédé est avantageusement réduit.

Selon un exemple, le procédé comprend en outre, après dépôt de la couche à base du matériau semi-métallique, un recuit de cristallisation.

Selon un exemple, la couche à base du matériau semi-métallique est recouverte préalablement au recuit de cristallisation, et le recuit de cristallisation est effectué à une température supérieure à la température de fusion du matériau semi-métallique.

Selon un exemple, les deuxièmes ouvertures sont reformées en exposant successivement un seul flanc des deuxièmes couches, et le dépôt de la couche à base du matériau semi-métallique forme un seul contact parmi les contacts de source et de drain.

Selon un exemple, l'autre contact parmi les contacts de source et de drain est un contact métallique formé par dépôt d'une couche métallique dans une partie des deuxièmes ouvertures.

Selon un exemple, le dépôt de la couche à base du matériau semi-métallique est effectué par croissance, de préférence par épitaxie, à partir de zones exposées dudit contact métallique au travers des deuxièmes espaces.

L'invention porte d'une manière générale sur un procédé de fabrication d'un dispositif microélectronique à transistors GAA, à base d'un matériau semi-métallique. Un tel dispositif microélectronique peut présenter une architecture de type « GAA stacked nanosheet », c'est-à-dire à nanofeuilles empilées et grille totalement enrobante. Une architecture à nanofils empilés et grille totalement enrobante est également possible.

Les nanofils ou nanofeuilles comprennent typiquement chacun un canal de conduction d'un transistor. Ces canaux sont empilés selon une direction z. Cela signifie qu'ils occupent chacun un niveau d'altitude donnée selon la direction z. Un niveau peut être défini entre deux plans perpendiculaires à la direction z.

De manière avantageuse, le procédé selon l'invention peut être mis en oeuvre pour la réalisation de transistors MOS GAA pour les noeuds technologiques 5 nm et sub-5 nm.

Un dispositif microélectronique comprenant des transistors GAA peut être avantageusement intégré dans des systèmes logiques présentant des architectures 3D. Ces transistors peuvent notamment être associés à d'autres éléments structuraux ou fonctionnels de façon à concevoir des systèmes complexes.

Un aspect particulier de l'invention concerne la mise en oeuvre de matériaux semi-métalliques pour réaliser les nanofils ou nanofeuilles du dispositif. Ces matériaux semi-métalliques peuvent présenter des propriétés d'un métal ou d'un semiconducteur, typiquement en fonction de la température ou d'un confinement dimensionnel. La structure de bandes des matériaux semi-métalliques ou semimétaux les rapproche des métaux, dans la mesure où ces matériaux n'ont pas de bande interdite, mais la faible densité d'états électroniques au niveau de Fermi scinde les porteurs en deux populations, électrons et trous, comme pour les semiconducteurs. Ainsi, il est possible d'agir sur le type de conduction électrique des matériaux semi-métalliques, en modifiant leurs dimensions. Lorsqu'on diminue les dimensions d'un semimétal, la concentration des porteurs est d'abord quasiment constante, comme dans les métaux, puis croit sensiblement par confinement quantique, comme dans les semiconducteurs. On observe ainsi une transition semimétal-semiconducteur. Le bismuth peut se comporter comme un semiconducteur lorsqu'il est déposé en couches minces d'épaisseur inférieure à une valeur critique de 30 nm.

Dans le cadre de la présente invention, les matériaux semi-métalliques sont de préférence à base de bismuth (Bi), d'étain (Sn), d'antimoine (Sb), d'arsenic (As), de tellure (Te). D'autres matériaux présentant des propriétés semi-métalliques, au moins sous certaines conditions, sont également envisageables. Certains alliages peuvent être semimétalliques, comme le tellurure de mercure HgTe. Certains polymères conducteurs peuvent présenter des phases semimétalliques ; certaines structures de graphène en couche mince, par exemple, peuvent être semimétalliques en fonction de leur environnement magnétique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stoechiométrique (SiN), ou du nitrure de silicium stoechiométrique (Si3N4), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Les différents motifs formés au cours des étapes de fabrication présentent typiquement une structure destinée à évoluer lors des étapes du procédé. Ainsi, les motifs peuvent comprendre les couches sacrificielles de l'empilement initial, les couches à base de matériau semi-métallique, les couches diélectriques, continues ou discontinues. Les différents motifs visent à former, en fin de procédé, des « motifs de transistors » comprenant chacun au moins un canal de conduction et une grille entourant ledit canal, une barrière diélectrique séparant la grille et le canal, une source et un drain de part et d'autre du canal. L'assignation des premières et deuxièmes couches dans l'empilement initial peut être inversée.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy.

Dans la présente demande de brevet, la direction longitudinale correspond à la direction selon laquelle s'étend le canal d'un transistor, entre la source et le drain. La direction longitudinale est dirigée selon x sur les figures d'illustration. Une direction transverse est dirigée selon y ou z. Une dimension transverse est typiquement prise selon y ou z. L'épaisseur de la couche formant le canal est une dimension transverse du canal.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente un exemple de mise en oeuvre du procédé selon l'invention dans un contexte d'élaboration d'un dispositif 3D complexe. Le cadre de cette description n'est évidemment pas limitatif de l'invention.

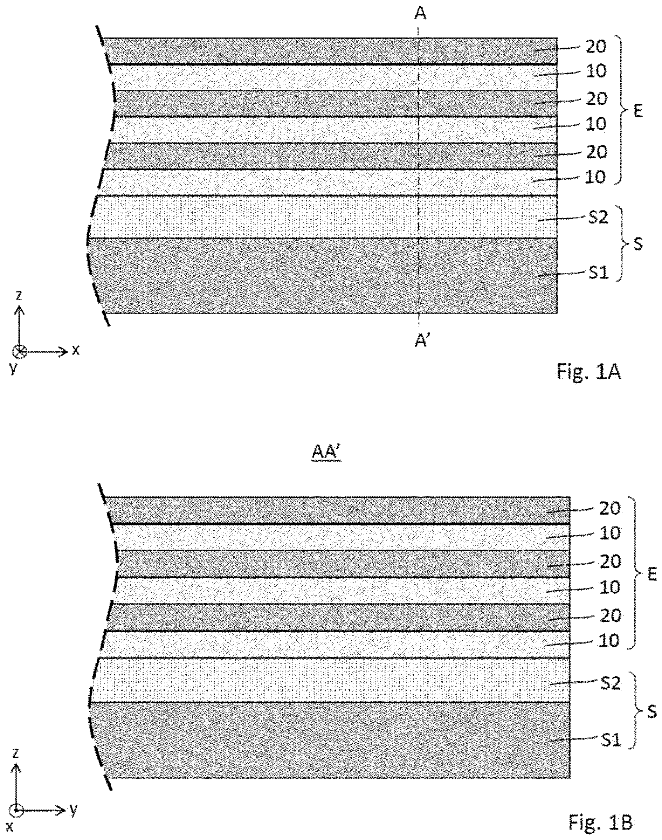

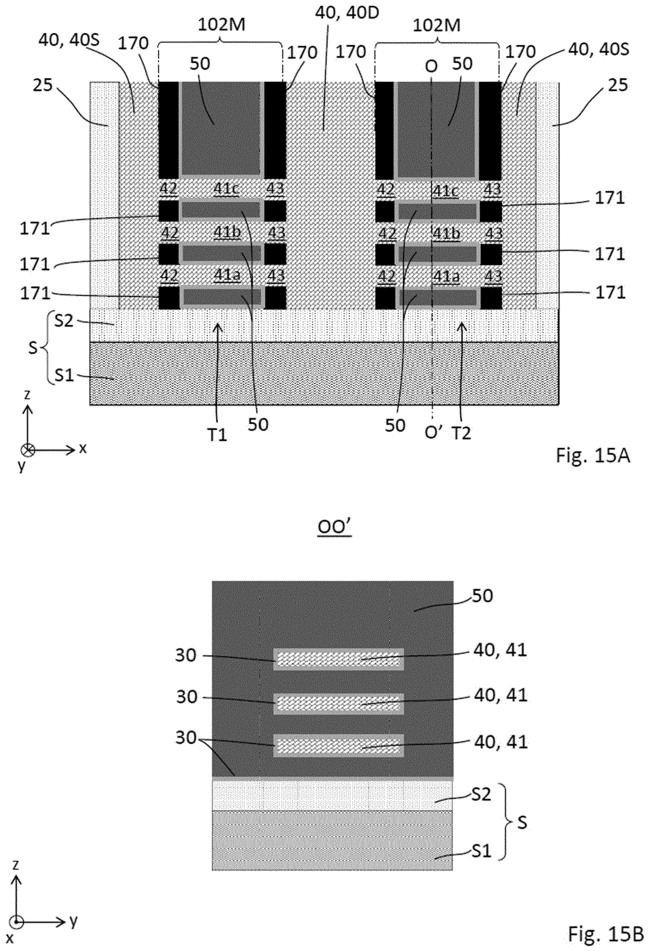

Les figures 1A, 1B à 15A, 15B illustrent schématiquement des étapes de fabrication d'un dispositif comprenant des transistors GAA à base d'un matériau semi-métallique, selon un premier mode de réalisation. Les figures nA (n=1...15) correspondent à des premières coupes transverses selon un plan xz illustrant chacune une étape différente du procédé de fabrication. Les figures nB (n=1...15) correspondent à des deuxièmes coupes transverses selon un plan yz illustrant chacune la même étape que la figure nA correspondante.

Comme illustré aux figures 1A, 1B, une première étape consiste à réaliser un empilement E de couches semi-conductrices 10, 20 sur un substrat S. Le substrat S peut être un substrat de type SOI (Silicon On Insulator), GeOI (Germanium On Insulator) ou SGOI (Silicon-Germanium On Insulator). Ces substrats sont regroupés sous la dénomination « semiconducteur-sur-isolant ». Ces substrats connus comprennent, selon la terminologie courante pour l'homme du métier, une couche de support S1 de silicium épaisse dite « Si bulk », une couche isolante S2 d'oxyde de silicium dite « BOX » (Burried Oxide) et une couche mince superficielle, respectivement à base de silicium, de germanium ou de silicium-germanium. Cette couche mince superficielle peut avantageusement correspondre à la première couche 10 de l'empilement E. Dans ce cas, le dispositif final comprenant des transistors GAA à base d'un matériau semi-métallique repose sur la couche isolante (BOX) du substrat de type semiconducteur-sur-isolant.

Alternativement, le substrat S peut être un substrat massif « Si bulk ».

L'empilement E comprend selon un exemple une alternance de premières couches 10 en silicium-germanium (SiGe) et de deuxièmes couches 20 en silicium (Si).

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe. Cet empilement E est avantageusement formé par épitaxie des couches de SiGe 10 et de Si 20. Cette étape de formation de l'empilement E est peu coûteuse et bien connue de l'homme du métier. Les épaisseurs des couches Si et SiGe peuvent être comprises entre 5 nm et 20 nm, et de préférence entre 4 nm et 10 nm. De façon connue afin d'éviter la formation de défauts structuraux, les épaisseurs maximales permises pour les couches 10 en SiGe dépendent notamment de la concentration en Ge choisie.

Dans l'exemple illustré aux figures 1A, 1B trois couches 10 de SiGe sont alternées avec trois couches 20 de Si épitaxiées. Un super réseau Si/SiGe est ainsi obtenu. Le nombre de couches de Si et de SiGe peut naturellement être augmenté. Cela permet *in fine* d'augmenter le nombre de canaux empilés par transistor dans le dispositif final.

D'une façon générale le premier matériau des premières couches 10 et le deuxième matériau des deuxièmes couches 20 sont choisis de façon à ce que l'un puisse être gravé sélectivement par rapport à l'autre. Ainsi, d'autres couples de premier et deuxième matériaux sont possibles. En respectant cette condition de sélectivité à la gravure, les premier et deuxième matériaux peuvent être choisis parmi les matériaux diélectriques (oxydes et nitrures par exemple), les matériaux semiconducteurs, les matériaux métalliques.

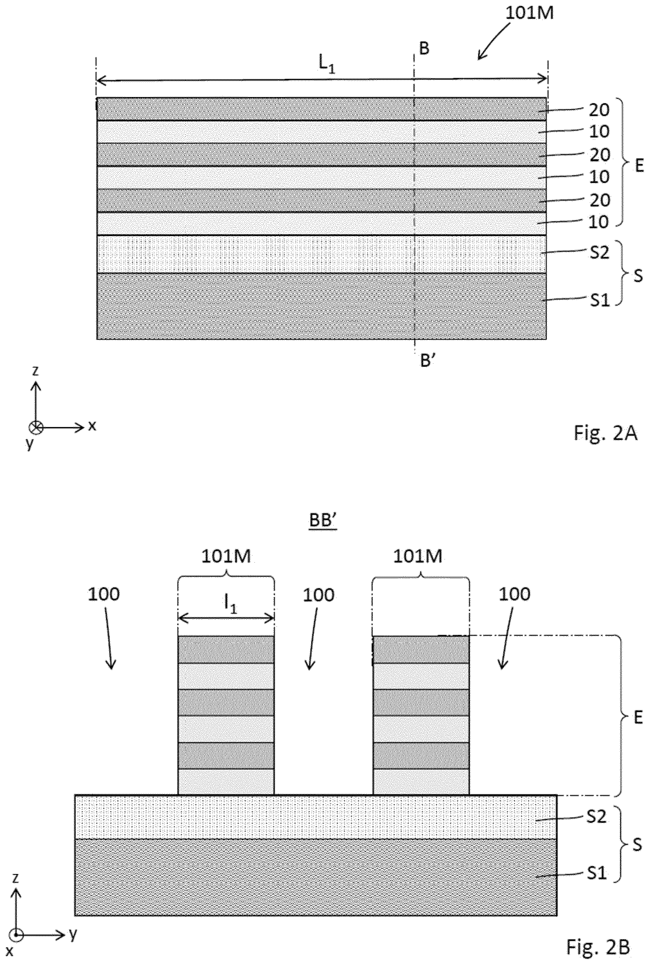

Comme illustré aux figures 2A, 2B, une étape classique de lithographie/gravure est réalisée afin de définir des premiers motifs 101M, et des premières ouvertures 100. La gravure est anisotrope et dirigée selon z. Elle est configurée pour graver l'empilement E, ici le super réseau Si/SiGe, sur toute sa hauteur, en s'arrêtant sur le substrat S, ici le BOX S2. Elle peut être effectuée par plasma en utilisant une chimie de gravure HBr/O2. Les premiers motifs 101M peuvent présenter une longueur L₁ selon x comprise entre 10 nm et 500 nm. Ils présentent de préférence une largeur I₁ selon y comprise entre 5 nm et 20 nm. Cette première structuration de l'empilement E sous forme d'ailettes ou « fins » selon la terminologie anglo-saxonne courante, permet de définir une pluralité de nanofils ou de nanosheets superposés.

Par souci de clarté les figures suivantes iB (i=3...15) n'illustrent qu'un seul motif de « fin » 101M.

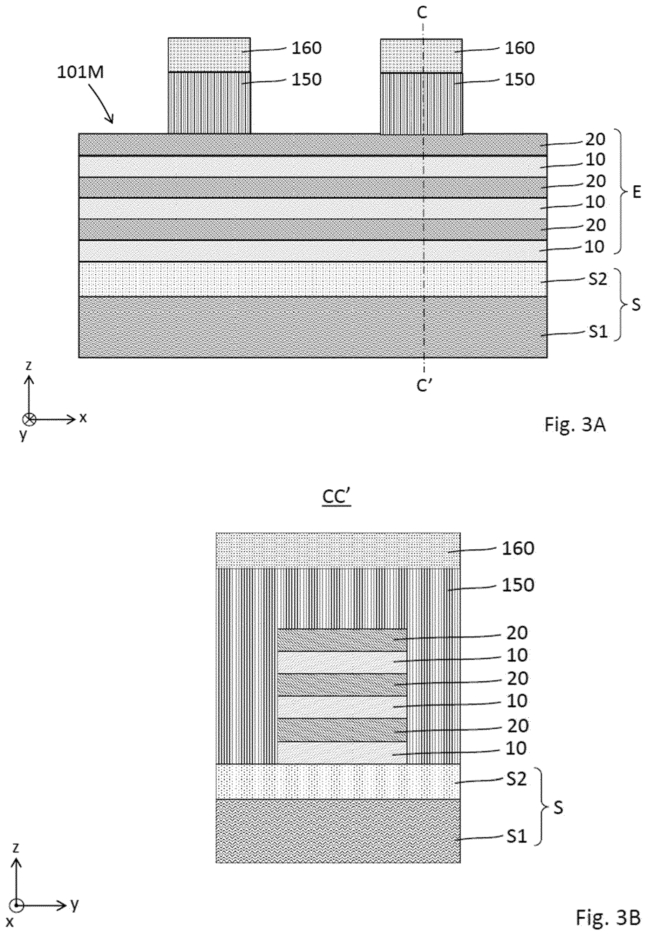

Comme illustré aux figures 3A, 3B, des grilles sacrificielles 150 sont ensuite formées sur les motifs de « fin » 101M. La formation de ces grilles sacrificielles 150 se fait typiquement par dépôt puis lithographie/gravure. La formation des grilles sacrificielles 150 est configurée de sorte que les grilles sacrificielles 150 soient à cheval sur les motifs de « fin » 101M, comme illustré en figure 3B. Les grilles sacrificielles 150 comprennent typiquement une partie supérieure située sur le motif de « fin » 101M, et des parties latérales situées sur les flancs latéraux du motif de « fin » 101M. Les grilles sacrificielles 150 prennent typiquement appui sur le substrat S. A ce stade, les grilles sacrificielles 150 sont typiquement surmontées par un masque de gravure 160, dit masque dur, mis en oeuvre dans la structuration des grilles sacrificielles 150. Les grilles sacrificielles 150 sont par exemple à base de silicium polycristallin. Une fine couche d'oxyde SiO₂, d'épaisseur 7 nm par exemple, est de préférence déposée préalablement à la formation des grilles sacrificielles 150. Cette fine couche d'oxyde SiO₂ (non illustrée sur les figures) est ainsi intercalée entre les grilles sacrificielles 150 et les motifs de « fin » 101M. Cette fine couche d'oxyde SiO₂ peut former une couche d'arrêt pour la gravure ultérieure des grilles sacrificielles 150.

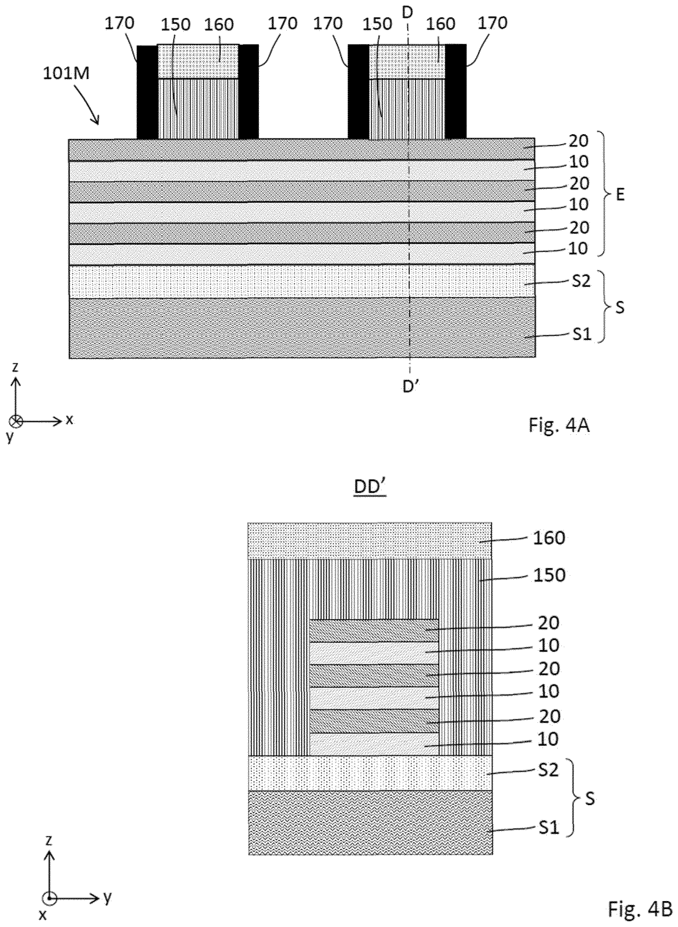

Comme illustré aux figures 4A, 4B, des premiers espaceurs 170 sont ensuite formés sur les flancs orientés selon yz des grilles sacrificielles 150. En général, en projection selon z, ces espaceurs forment une bague continue autour de chaque grille sacrificielle 150, avec un contour fermé. En coupe transverse cependant, selon le plan xz illustré à la figure 4A, le premier espaceur 170 présente deux parties en vis-à-vis sur chacun des flancs de la grille sacrificielle 150. Ces deux parties sont généralement désignées comme étant les premiers espaceurs 170, même si celles-ci peuvent être considérées comme appartenant à un seul et même espaceur. Les premiers espaceurs 170 s'étendent typiquement jusqu'à une face supérieure des masques durs 160. Les premiers espaceurs 170 sont typiquement à base de nitrure de silicium SiN ou d'un matériau diélectrique à faible constante diélectrique, par exemple à base de SiCO.

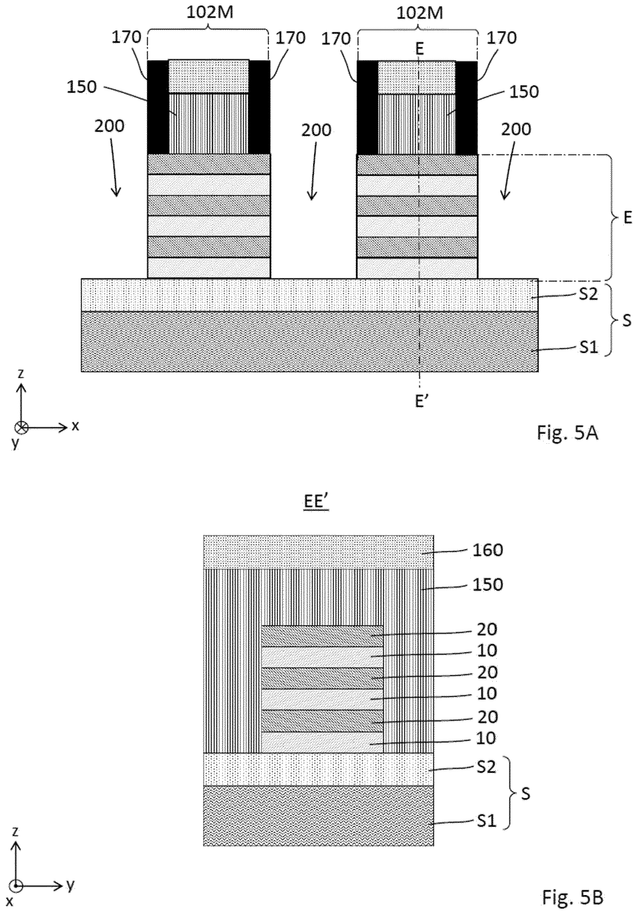

Comme illustré aux figures 5A, 5B, après formation des premiers espaceurs 170 par dépôt/gravure, la gravure anisotrope selon z est prolongée afin de définir des deuxièmes motifs 102M, et des deuxièmes ouvertures 200. La gravure est configurée pour graver l'empilement E sur toute sa hauteur, en s'arrêtant sur le substrat S. Elle peut être effectuée par plasma en utilisant une chimie de gravure HBr/O2.

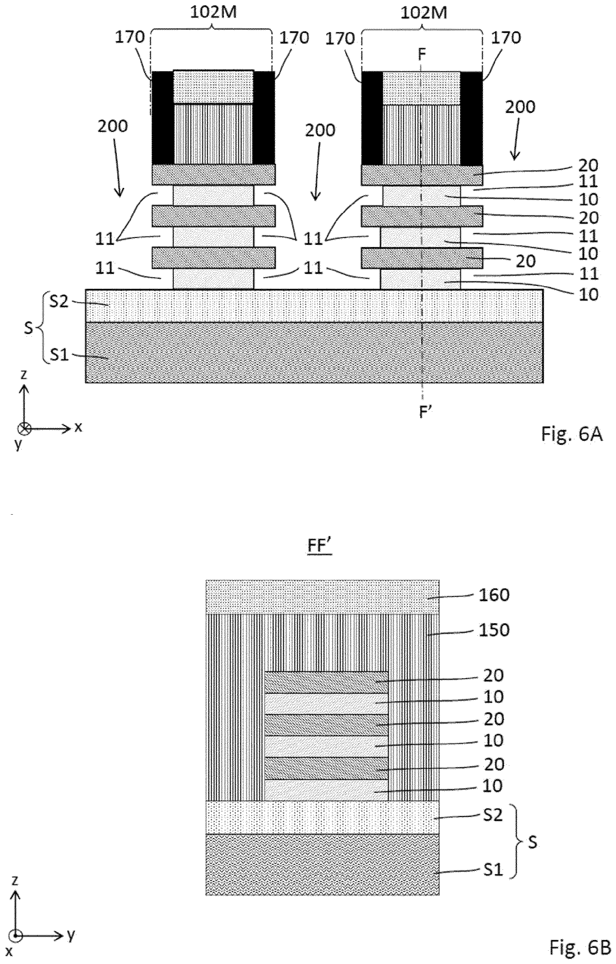

Comme illustré aux figures 6A, 6B, après formation des deuxièmes ouvertures 200, les premières couches 10 sont partiellement gravées sélectivement aux deuxièmes couches 20, au substrat S et aux premiers espaceurs 170. La gravure du premier matériau des premières couches 10 présente typiquement une sélectivité S_{10:20} par rapport au deuxième matériau des deuxièmes couches 20, d'au moins 5:1, de préférence au moins 10:1. Cette gravure partielle vise à former des premiers espaces 11 à l'aplomb des premiers espaceurs 170. Cette gravure partielle est typiquement arrêtée au temps. Elle présente un caractère isotrope et peut être effectuée par voie humide ou par voie sèche, à partir des deuxièmes ouvertures 200. A l'issue de cette gravure partielle, des parties centrales des premières couches 10 sont conservées sous les grilles sacrificielles 150.

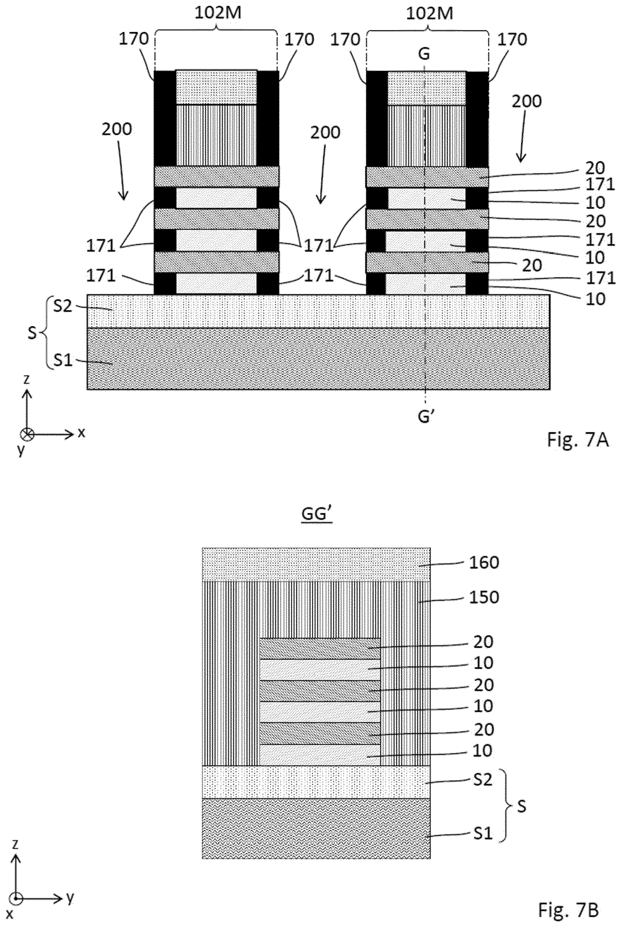

Comme illustré aux figures 7A, 7B, les premiers espaces 11 sont ensuite remplis par un matériau diélectrique, par exemple par du nitrure de silicium ou par un diélectrique à faible permittivité, pour former des espaceurs internes 171. Ces espaceurs « internes » 171 sont intégrés dans l'empilement E, de préférence à l'aplomb des premiers espaceurs 170. Ils sont au contact des parties centrales des premières couches 10. La formation des espaceurs internes 171 se fait typiquement à partir des deuxièmes ouvertures 200.

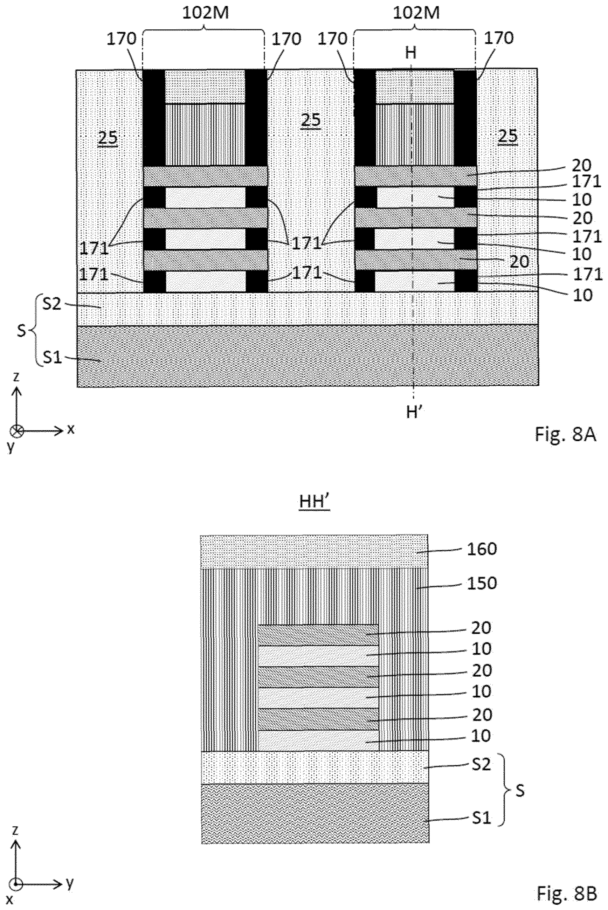

Comme illustré aux figures 8A, 8B, une couche de maintien 25, par exemple à base de SiO2, est déposée sur et entre les deuxièmes motifs 102M de façon à combler les ouvertures 200. Cette couche de maintien 25 est ensuite planarisée, typiquement par polissage mécano-chimique CMP avec arrêt sur les masques durs 160.

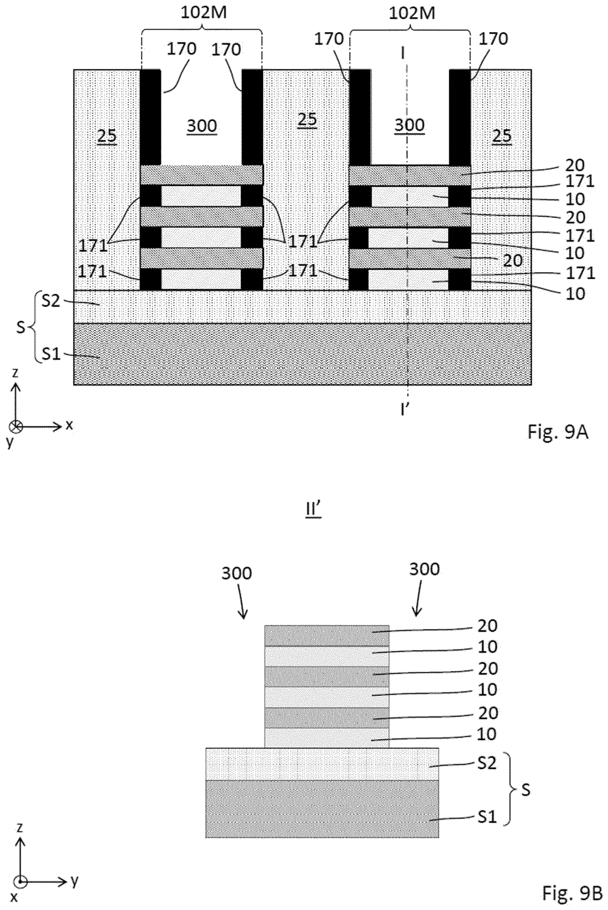

Comme illustré aux figures 9A, 9B, les masques durs 160 sont d'abord retirés, puis les grilles sacrificielles 150 sont également retirées. Ce retrait peut être effectué par gravure humide avec arrêt sur la fine couche d'arrêt à base de SiO2 ou d'un autre diélectrique. Cette gravure humide présente typiquement une sélectivité élevée vis-à-vis de la couche d'arrêt et des premiers espaceurs 170. Cette gravure humide peut être à base d'une solution de sels d'ammoniaque TMAH (Tetramethylammonium hydroxide) ou TEAH (Tetraethylammonium Hydroxide). La couche d'arrêt à base de SiO2 est ensuite typiquement gravée par voie humide pour exposer la face supérieure de la dernière couche de l'empilement E, ici une deuxième couche 20. Ce retrait des grilles sacrificielles 150 permet de former des troisièmes ouvertures 300 débouchant sur les parties centrales des premières couches 10 (figure 9B).

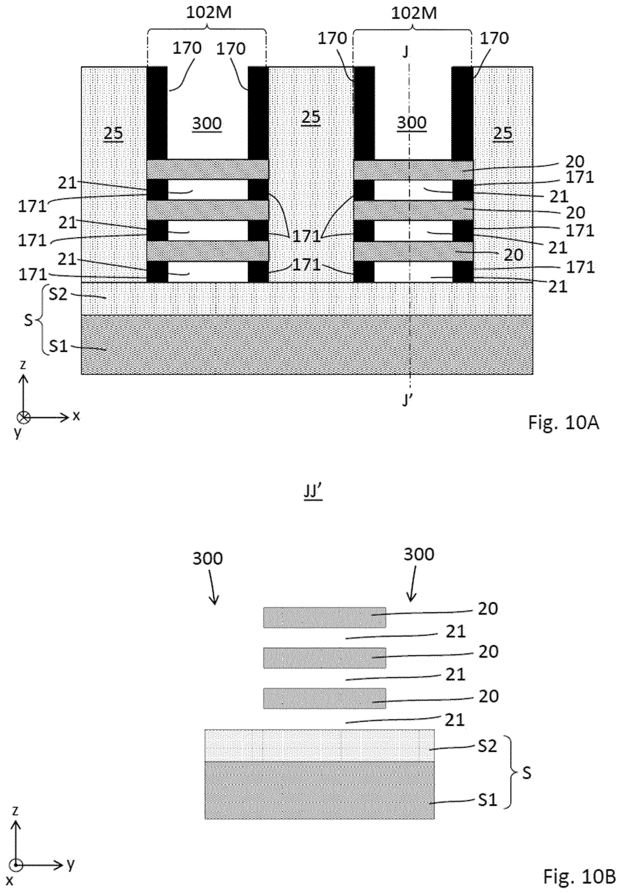

Comme illustré aux figures 10A, 10B, les parties centrales des premières couches 10 sont ensuite totalement gravées sélectivement aux deuxièmes couches 20, aux espaceurs internes 171, et au substrat S à partir des troisièmes ouvertures 300. Cette gravure vise à former des cavités 21 à la place des parties centrales des premières couches 10. Cette gravure totale peut être arrêtée au temps, possiblement après un temps de sur-gravure visant à garantir le retrait total du premier matériau des premières couches 10. Cette gravure totale présente un caractère isotrope et peut être effectuée par voie humide ou par voie sèche, à partir des troisièmes ouvertures 300. Les deuxièmes couches 20 sont maintenues par les espaceurs 170, 171 et par couche de maintien 25, comme illustré à la figure 10A.

Une étape avantageuse non illustrée sur les figures consiste à oxyder les parties exposées des deuxièmes couches 20 à partir des troisièmes ouvertures 300 et des cavités 21. Cela permet de diminuer l'épaisseur selon z et les dimensions latérales selon y du deuxième matériau des deuxièmes couches 20. Après remplacement du deuxième matériau des deuxièmes couches 20 pour former les canaux des transistors, cela permet d'obtenir *in fine* des canaux ayant des dimensions réduites selon z et selon y. Les canaux des transistors peuvent ainsi présenter des dimensions selon z et selon y de l'ordre de quelques nanomètres.

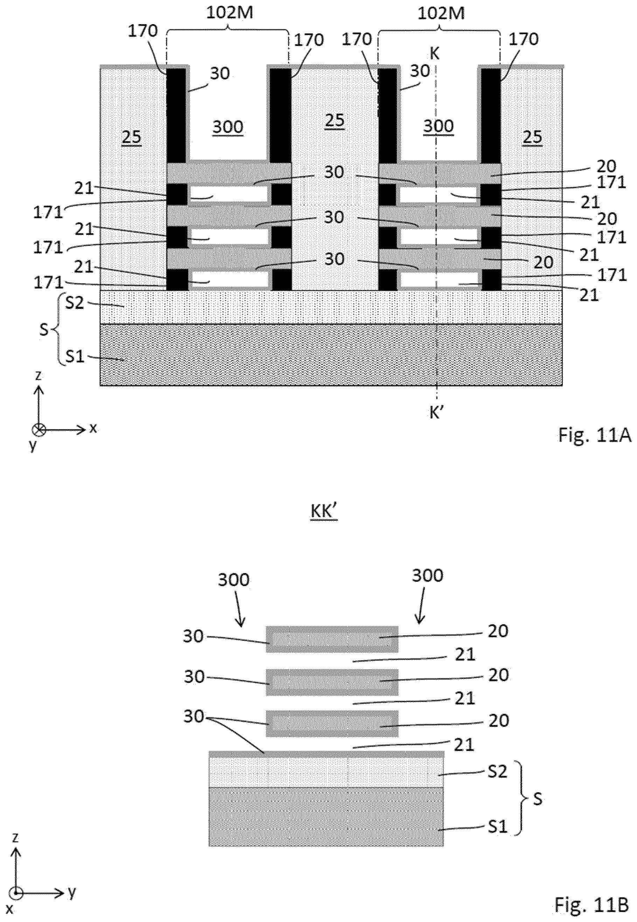

Comme illustré aux figures 11A, 11B, une couche diélectrique 30 est ensuite déposée dans les cavités 21 à partir des ouvertures 300. Cette couche diélectrique 30 est typiquement à base d'un matériau à forte permittivité, par exemple à base de HfO2. La couche diélectrique 30 est typiquement destinée à former la couche diélectrique de grille entre les canaux des transistors GAA et leurs grilles enrobantes. Elle peut être formée par dépôt chimique en phase vapeur CVD (acronyme de « Chemical Vapor Déposition »), par dépôt chimique en phase vapeur à précurseurs organométalliques MOCVD (acronyme de « Metal Organic Chemical Vapor Déposition ») ou par dépôt en couche atomique ALD (acronyme de « Atomic Layer Déposition »). Elle recouvre ainsi au moins les parties exposées des deuxièmes couches 20, et de préférence des premiers espaceurs 170 et des espaceurs internes 171, et la face supérieure exposée du substrat S. La couche diélectrique 30 présente typiquement une épaisseur comprise entre 1 nm et 5 nm.

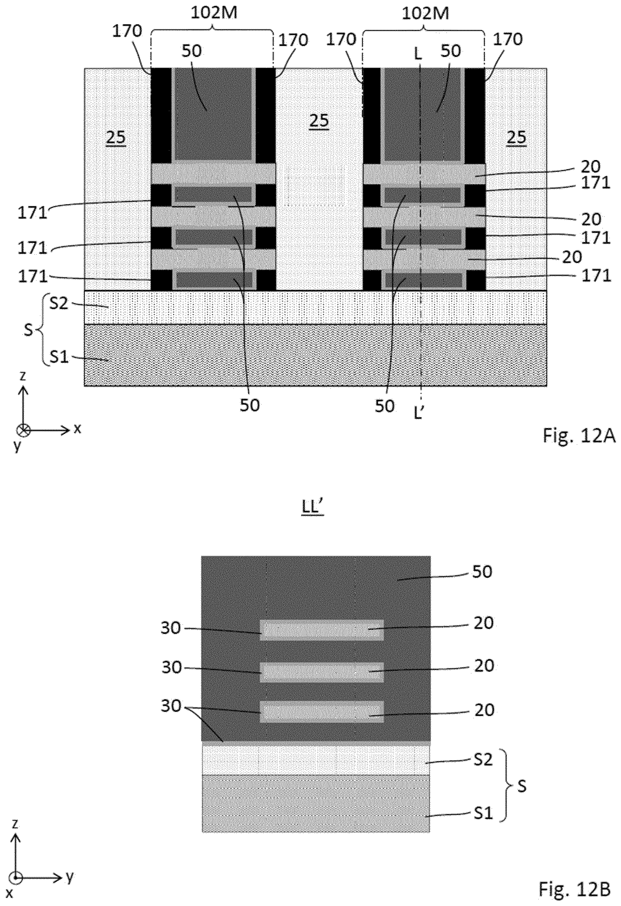

Comme illustré aux figures 12A, 12B, les troisièmes ouvertures 300 et les cavités 21 sont ensuite remplies par une ou plusieurs couches métalliques 50, par exemple à base de TiN, W, afin de former les grilles enrobantes des transistors GAA. Selon une possibilité, avant dépôt des couches métalliques 50, une couche diélectrique à base d'un matériau à forte permittivité, par exemple à base de HfO2, est préalablement déposée dans les troisièmes ouvertures 300 et les cavités 21. Cela permet d'augmenter l'épaisseur de la couche diélectrique de grille entre les canaux des transistors GAA et leurs grilles 50 enrobantes. Un polissage mécano-chimique CMP est typiquement effectué afin de retirer l'excès de métal déposé sur les motifs 102M.

Les étapes du procédé décrites ci-dessus sont communes aux premier et deuxième modes de réalisation de la présente invention. Les étapes suivantes du procédé sont décrites ci-après pour chacun des deux modes de réalisation.

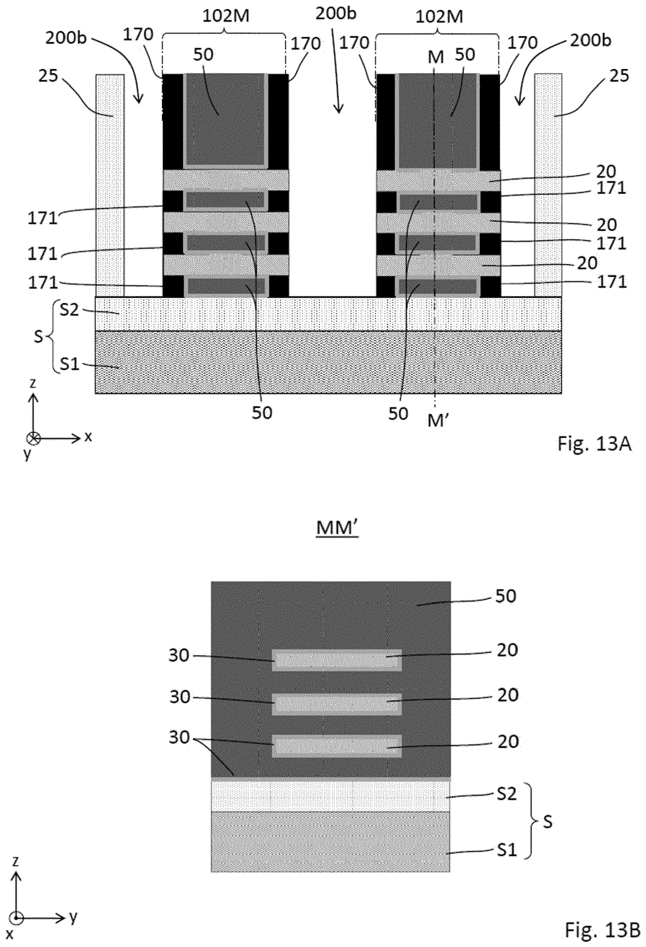

Les figures 13A, 13B, 14A, 14B, 14C, 15A et 15B illustrent schématiquement selon le premier mode de réalisation, la suite des étapes de fabrication du procédé permettant la réalisation du dispositif comprenant des transistors GAA à canaux empilés à base d'un matériau semi-métallique.

Selon ce premier mode de réalisation, comme illustré aux figures 13A, 13B, la couche de maintien 25 est ouverte par gravure de façon à reformer en partie les deuxièmes ouvertures 200b. Ces deuxièmes ouvertures 200b définissent les régions des contacts de source et de drain. Les deux flancs selon yz de chaque motif 102M sont exposés à travers ces deuxièmes ouvertures 200b.

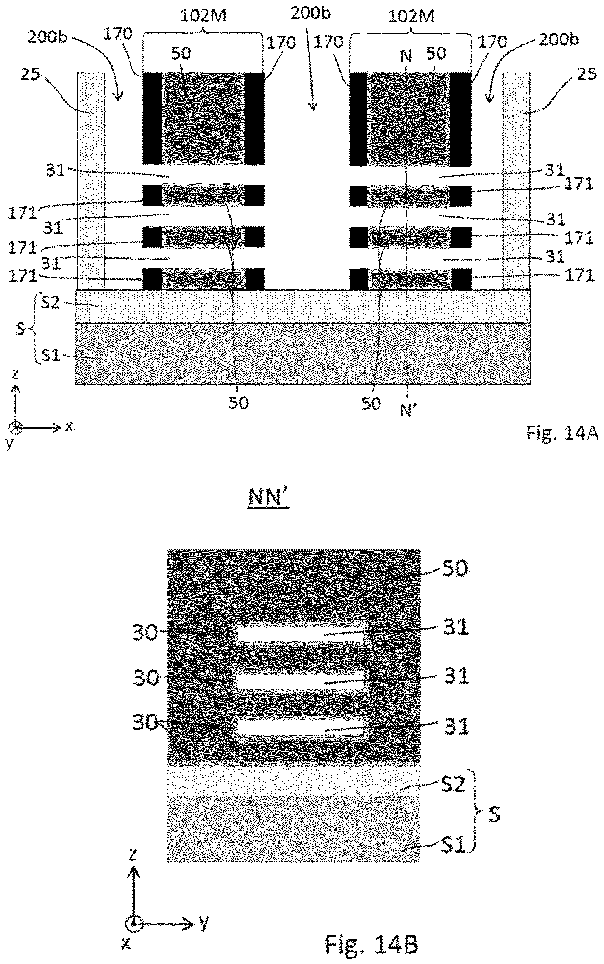

Comme illustré aux figures 14A, 14B, 14C, les deuxièmes couches 20 sont ensuite totalement retirées par gravure sélective vis-à-vis de la grille 50, de la couche diélectrique 30 et des espaceurs 170, 171. Cette gravure peut être arrêtée au temps, possiblement après un temps de surgravure visant à garantir le retrait total du deuxième matériau des deuxièmes couches 20. Cette gravure totale présente un caractère isotrope et peut être effectuée par voie humide ou par voie sèche, à partir des deuxièmes ouvertures 200b. A l'issue de cette gravure, des deuxièmes espaces 31 sont formés à la place des deuxièmes couches 20. Les deuxièmes ouvertures 200b définissent les emplacements des contacts de source et de drain. Les deuxièmes espaces 31 définissent les emplacements des canaux, des drains et des sources.

La figure 14C illustre une variante dans laquelle la section des deuxièmes espaces 31, et par suite des canaux des transistors, est ronde ou ovoïde. Une telle forme arrondie peut être obtenue par oxydation des deuxièmes couches 20 après formation des troisièmes ouvertures 300 (retrait de la grille sacrificielle) et des cavités 21 illustrées à la figure 10A. Plus généralement, il est entendu que cette section peut adopter l'une des formes géométriques suivantes : rectangulaire comme illustré à la figure 14B, elliptique ou ovoïde comme illustré à la figure 14C, circulaire, carrée, rectangulaire aux angles arrondis ou carrée aux angles arrondis. Quelle que soit la forme géométrique de cette section transverse selon yz, sa dimension selon z est de préférence comprise entre 2 nm et 15 nm.

Comme illustré aux figures 15A, 15B, une couche 40 à base d'un matériau semi-métallique est ensuite déposée dans les deuxièmes ouvertures 200b dans les deuxièmes espaces 31. Le matériau semi-métallique peut comporter avantageusement du bismuth. Ainsi, ce matériau semi-métallique peut correspondre à du bismuth ou un alliage comprenant du bismuth et au moins l'un des matériaux suivants : étain, antimoine, arsenic.

Le dépôt d'un tel matériau semi-métallique peut se faire par MOCVD, ALD ou par une combinaison de ces méthodes, en utilisant par exemple l'un ou plusieurs des gaz précurseurs suivants : Bis(acétate-O) triphénylbismuth(V) (CH₃CO₂)₂Bi(C₆H₅)₃), triphénylbismuth (Bi(C₆H₅)₃), et Tris(2-méthoxyphényl)bismuthine ((CH₃OC₆H₄)₃Bi). Le matériau semi-métallique peut être dopé *in situ* lors du dépôt. Dans le cas du matériau semi-métallique à base de bismuth, un exemple de dopant de type N est l'élément tellure (Te). Le dopage *in situ par* l'élément Te peut être réalisé en utilisant un ou plusieurs des gaz précurseurs suivants : tétrabromure de tellure anhydre (TeBr₄), tétrachlorure de tellure (TeCl₄). La concentration de Te dans le matériau semi-métallique à base de bismuth dopé N est typiquement comprise entre 10¹⁷ cm⁻³ et 5×10²⁰ cm⁻³.

Le dépôt du matériau semi-métallique est ici configuré pour que la couche 40 remplisse totalement les deuxièmes espaces 31 et les deuxièmes ouvertures 200b. Un recuit de cristallisation est effectué après dépôt, afin d'obtenir une structure cristalline pour la couche 40. Ce recuit de cristallisation peut comporter la mise en oeuvre des étapes suivantes :
- Un dépôt d'au moins un matériau diélectrique de recouvrement, recouvrant les parties exposées du matériau semi-métallique, puis
- Un recuit à une température supérieure à la température de fusion du matériau semi-métallique.

Après cristallisation du matériau semi-métallique, la couche 40 forme à la fois les canaux 41a, 41b, 41c des transistors GAA T1, T2, les sources 42 et les drains 43 des transistors GAA T1, T2, et les contacts de source et de drain 40S, 40D. Les canaux 41a, 41b, 41c et les sources 42 et les drains 43 présentent avantageusement des propriétés de conduction électrique d'un semiconducteur, par constriction du matériau semi-métallique de la couche 40. Les contacts de source et de drain 40S, 40D présentent avantageusement des propriétés de conduction électrique d'un métal. Ainsi, le dépôt et le recuit de cristallisation de la couche 40 forment une pluralité d'éléments fonctionnels des transistors T1, T2, en un minimum d'étapes.

Dans ce procédé, la portion de matériau semi-métallique formant le canal n'est pas réalisée au préalable par croissance sur un substrat métallique, mais par dépôt du matériau semi-métallique dans l'emplacement de canal.

Ce procédé se base typiquement sur la réalisation d'un « moule » formé par les emplacements de canal et de contacts de source et de drain, dans lequel le matériau semi-métallique est ensuite déposé. Le dépôt du matériau semi-métallique dans ce moule permet de contraindre la forme que prendra le matériau semi-métallique après sa cristallisation. Cela permet également d'éviter au matériau semi-métallique de présenter des surfaces rugueuses.

Le comportement semi-conducteur des canaux 41a, 41b, 41c est obtenu par effet quantique de confinement des porteurs de charges (électrons). Lorsque le matériau semi-métallique est par exemple du bismuth, cet effet quantique de confinement peut être obtenu pour des dimensions de l'ordre de 15 nm, à température ambiante. Lorsque le matériau semi-métallique est par exemple de l'étain, cet effet peut être obtenu pour des dimensions de l'ordre d'environ 2 nm à température ambiante.

Le recuit de cristallisation est de préférence mis en oeuvre à une température supérieure à la température de fusion du matériau semi-métallique. Lorsque ce matériau semi-métallique correspond à du bismuth, ce recuit est mis en oeuvre à une température supérieure à 271°C.

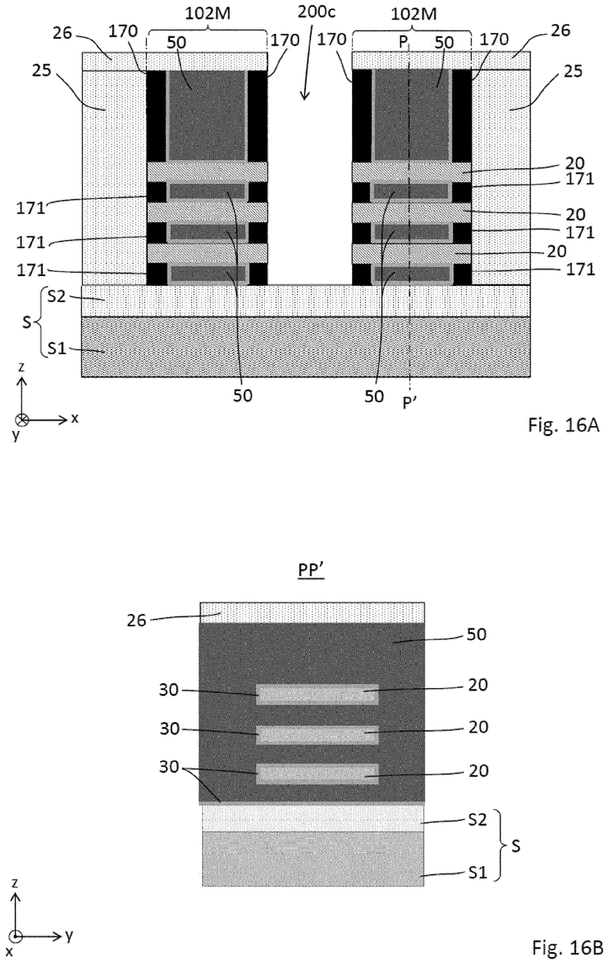

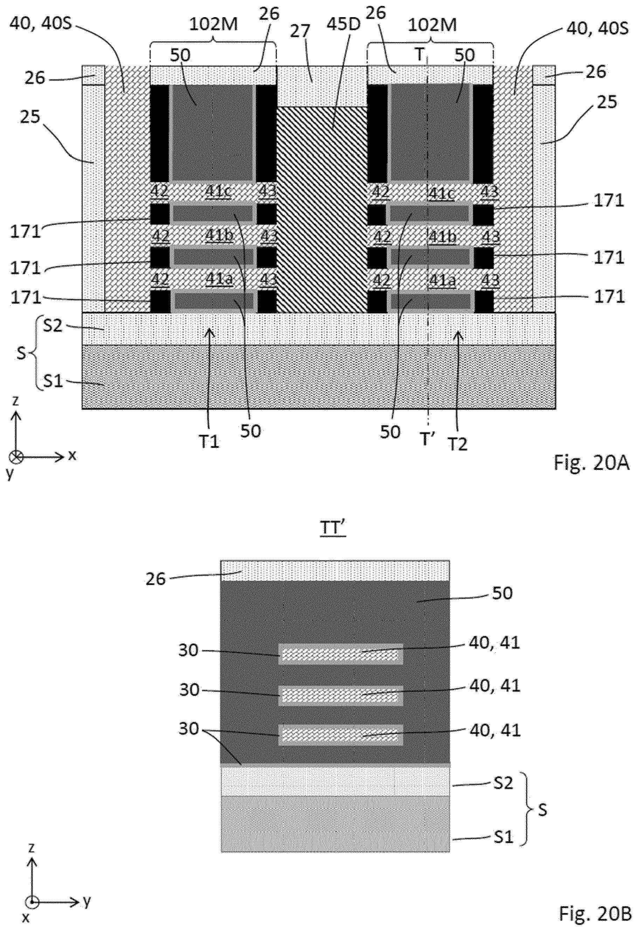

Les figures 16A, 16B à 20A, 20B illustrent schématiquement un deuxième mode de réalisation du procédé de fabrication du dispositif comprenant des transistors GAA à canaux empilés à base d'un matériau semi-métallique.

Selon ce deuxième mode de réalisation, comme illustré aux figures 16A, 16B, une partie de la couche de maintien 25 et les motifs 102M sont masqués par dépôt d'une deuxième couche diélectrique 26, afin d'ouvrir uniquement la région de drain située entre les deux motifs 102M. La ou les deuxièmes ouvertures 200c correspondent ici à la définition d'un seul type de contact, par exemple les contacts de drain. Un seul flanc selon yz de chaque motif 102M est ainsi exposé au travers des deuxièmes ouvertures 200c.

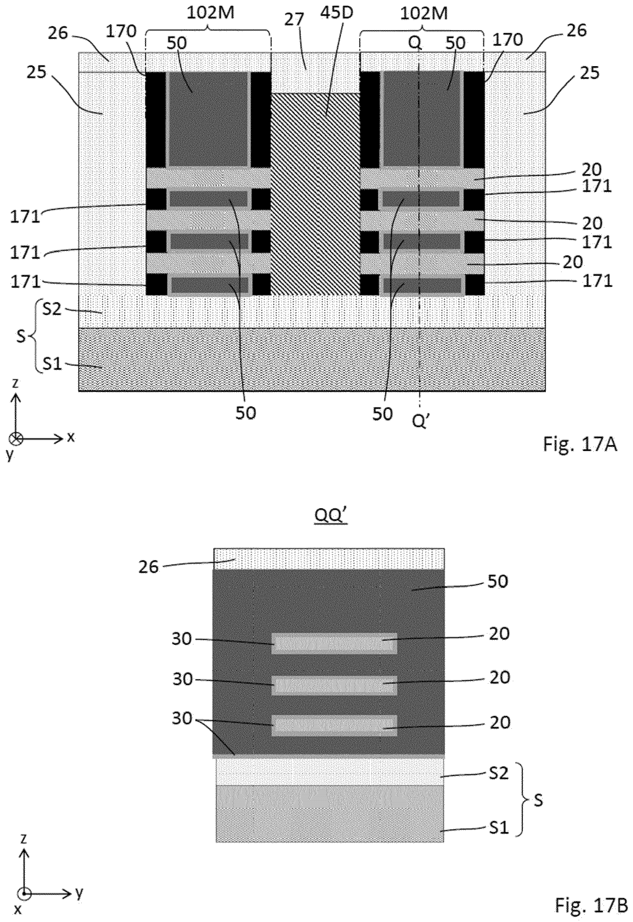

Comme illustré aux figures 17A, 17B, une couche à base d'un matériau métallique est ensuite déposée dans la deuxième ouverture 200c pour former le contact de drain 45D. Le matériau métallique du contact de drain 45D peut être classiquement à base de l'un des métaux suivants : cuivre (Cu), cobalt (Co), or (Au), titane (Ti), aluminium (AI), nickel (Ni), tungstène (W), nitrure de titane (TiN), ou d'autres métaux. Un bouchon diélectrique 27 est ensuite formé sur le contact de drain 45D, afin de protéger la partie exposée de ce contact de drain 45D.

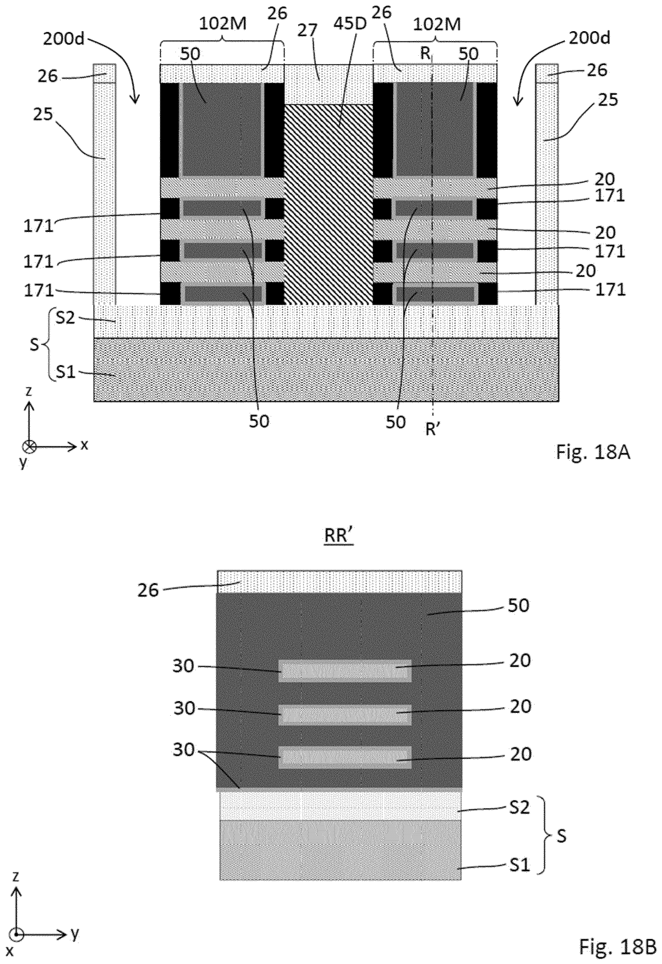

Comme illustré aux figures 18A, 18B, des deuxièmes ouvertures 200d sont ensuite formées dans la couche de maintien 25. Les deuxièmes ouvertures 200d correspondent ici à la définition de l'autre type de contact, par exemple les contacts de source. L'autre flanc selon yz de chaque motif 102M est ainsi exposé au travers des deuxièmes ouvertures 200d.

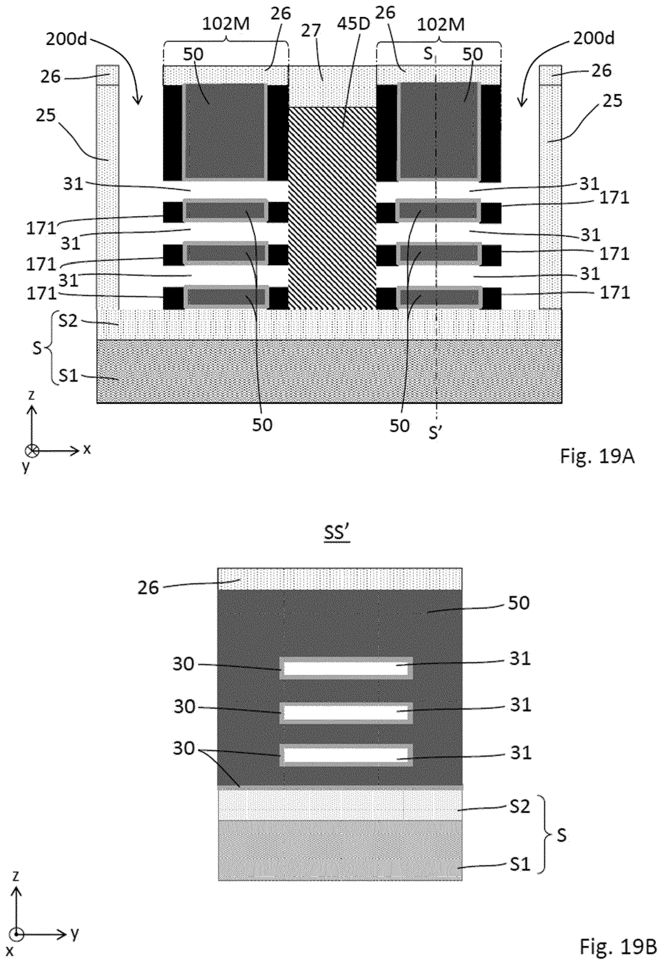

Comme illustré aux figures 19A, 19B, les deuxièmes couches 20 sont ensuite totalement retirées par gravure sélective vis-à-vis de la couche diélectrique 30, des espaceurs 170, 171, et du contact 45D. Cette gravure totale peut se faire comme précédemment, à partir des deuxièmes ouvertures 200d. A l'issue de cette gravure, les deuxièmes espaces 31 sont formés à la place des deuxièmes couches 20.

Comme illustré aux figures 20A, 20B, la couche 40 à base du matériau semi-métallique est ici formée dans les deuxièmes espaces 31 par croissance à partir du contact 45D. Le métal du contact 45D forme typiquement un substrat pour l'épitaxie du matériau semi-métallique de la couche 40. Comme précédemment, une étape de cristallisation du matériau semi-métallique est de préférence effectuée.

La couche 40 forme comme précédemment les canaux 41a, 41b, 41c, les sources 42 et les drains 43 des transistors GAA T1, T2. La couche 40 forme ici uniquement les contacts de source 40S des transistors GAA T1, T2.

Un dispositif microélectronique comprenant au moins deux transistors T1, T2, à canaux 41a, 41b, 41c empilés selon z et à grille enrobante 50, est ainsi avantageusement obtenu. Les canaux 41a, 41b, 41c, les sources 42 et les drains 43 sont avantageusement à base d'un matériau semi-métallique. Au moins l'un des contacts de source 40S et de drain 40D est également à base de ce matériau semi-métallique.

Les dimensions nanométriques selon y et/ou selon z des canaux 41a, 41b, 41c, permettent au matériau semi-métallique d'adopter les propriétés d'un semi-conducteur. En outre, les plus grandes dimensions des contacts de source et de drain 40S, 40D, permettent au matériau semi-métallique d'adopter les propriétés d'un matériau métallique.

Au vu de la description qui précède, il apparaît clairement que le procédé proposé offre une solution particulièrement efficace pour former des transistors GAA à base de matériau semi-métallique. Cette solution est en outre avantageusement compatible avec les procédés standards de la microélectronique. L'invention n'est cependant pas limitée aux modes de réalisations précédemment décrits.

## Revendications

1. Dispositif microélectronique comprenant au moins un transistor (T1, T2) comprenant :
• une source (42) et un drain (43),
• une pluralité de canaux (41a, 41b, 41c) à base d'un matériau semi-métallique, lesdits canaux s'étendant selon une direction longitudinale (x) entre la source (42) et le drain (43), chaque canal présentant au moins une dimension transverse, prise perpendiculairement à la direction longitudinale (x), telle que le matériau semi-métallique présente une propriété de conduction électrique d'un matériau semiconducteur,
• une grille (50) dite enrobante, entourant au moins un des canaux (41a, 41b, 41c), et de préférence plusieurs canaux (41a, 41b, 41c) de la pluralité de canaux (41a, 41b, 41c),
• une couche diélectrique de grille (30) séparant chaque canal (41a, 41b, 41c) de la grille (50) enrobante,
• des contacts (40S, 40D) de source et de drain électriquement connectés respectivement à la source (42) et au drain (43), l'un au moins parmi les contacts (40S, 40D) de source et de drain étant à base du matériau semi-métallique et présentant des dimensions telles que le matériau semi-métallique présente une propriété de conduction électrique d'un matériau métallique,
• des espaceurs (170, 171) de part et d'autre de la grille (50), configurés pour isoler électriquement la grille (50) vis-à-vis des contacts (40S, 40D) de source et de drain,
le dispositif étant **caractérisé en ce que** la grille (50) enrobante entoure totalement plusieurs canaux (41a, 41b, 41c) de la pluralité de canaux (41a, 41b, 41c), dans un plan transverse (yz) perpendiculaire à la direction longitudinale (x), et **en ce que** ledit dispositif repose directement sur une couche isolante (S2) d'un substrat (S) de type semiconducteur-sur-isolant.

2. Dispositif selon la revendication précédente comprenant au moins deux transistors (T1, T2) disposés selon une première direction (x, y) dite horizontale, dans lequel les canaux (41a, 41b, 41c) de chaque transistor (T1, T2) sont empilés selon une deuxième direction (z) dite verticale, perpendiculaire à la première direction (x, y).

3. Dispositif selon l'une quelconque des revendications précédentes dans lequel l'autre parmi les contacts (40S, 40D) de source et de drain est à base d'un métal.

4. Dispositif selon l'une quelconque des revendications précédentes dans lequel le matériau semi-métallique est à base d'au moins un élément parmi le bismuth (Bi), l'étain (Sn), l'antimoine (Sb) ou l'arsenic (As).

5. Dispositif selon l'une quelconque des revendications précédentes dans lequel les contacts (40S, 40D) de source et de drain sont directement au contact de la couche isolante (S2).

6. Dispositif selon l'une quelconque des revendications précédentes dans lequel la grille (50) repose sur la couche isolante (S2) par l'intermédiaire de la couche diélectrique de grille (30) uniquement.

7. Dispositif selon l'une quelconque des revendications 1 à 5 dans lequel au moins un canal repose sur la couche isolante (S2) soit directement, soit par l'intermédiaire de la couche diélectrique de grille (30) uniquement.

8. Procédé de fabrication d'un dispositif microélectronique selon l'une quelconque des revendications précédentes, ledit procédé comprenant les étapes suivantes :
• Fournir, sur un substrat (S) comprenant une couche de support (S1) et une couche isolante (S2), un empilement (E) comprenant selon la direction (z) une pluralité de premières couches (10) en un premier matériau, alternées avec une pluralité de deuxièmes couches (20) en un deuxième matériau, le premier matériau et le deuxième matériau étant différents entre eux et différents du matériau semi-métallique formant les canaux (41a, 41b, 41c),
• Former dans cet empilement (E) des premières ouvertures (100) définissant des premiers motifs (101M),
• Former une grille sacrificielle (150) à cheval sur les premiers motifs (101M) et en partie dans les premières ouvertures (100),
• Former dans les premiers motifs (101M) des deuxièmes ouvertures (200) définissant des deuxièmes motifs (102M), tels que les deuxièmes motifs (102M) soient transverses aux premiers motifs (101M),
• Former la couche diélectrique de grille (30),
• Former les espaceurs de grille (170, 171),
• Former une couche de maintien (25) dans lesdites deuxièmes ouvertures (200), sur des flancs exposés des deuxièmes motifs (102M),
• Retirer la grille sacrificielle (150) de sorte à former des troisièmes ouvertures (300),
• Retirer totalement, à partir des troisièmes ouvertures (300), le premier matériau des premières couches (10) sélectivement au deuxième matériau des deuxièmes couches (20), de sorte à former des cavités (21),
• Remplir par un matériau de grille les cavités (21), de façon à former la grille (50) enrobante,
• Retirer au moins en partie la couche de maintien (25) de façon à reformer au moins en partie les deuxièmes ouvertures (200b) exposant des flancs des deuxièmes couches (20),
• Retirer totalement, à partir des deuxièmes ouvertures (200b), le deuxième matériau des deuxièmes couches (20) de sorte à former des deuxièmes espaces (31),
• Déposer une couche (40) à base d'un matériau semi-métallique dans les deuxièmes espaces (31) et au moins en partie dans les deuxièmes ouvertures (200b), de sorte à former simultanément :
∘ des canaux (41a, 41b, 41c) à base du matériau semi-métallique à l'aplomb de la grille (50) enrobante,
∘ au moins l'un parmi les contacts (40S, 40D) de source et de drain à base du matériau semi-métallique.

9. Procédé de fabrication selon la revendication précédente, dans lequel la grille (50) enrobante est formée avant le dépôt de la couche (40) à base du matériau semi-métallique.

10. Procédé de fabrication selon l'une quelconque des revendications 8 à 9, dans lequel la formation de la couche diélectrique de grille (30) est formée après retrait total du premier matériau des premières couches (11) et avant formation de la grille (50) enrobante, par dépôt d'une couche diélectrique dans les cavités (21) et dans les troisièmes ouvertures (300), sur les parties exposées des deuxièmes couches (20).

11. Procédé de fabrication selon l'une quelconque des revendications 8 à 10, dans lequel la formation des espaceurs (170, 171) et la formation de la couche diélectrique de grille (30) sont effectuées au moins en partie par un même dépôt d'une couche diélectrique dans les cavités (21).

12. Procédé de fabrication selon l'une quelconque des revendications 8 à 11, dans lequel les deuxièmes ouvertures (200c, 200d) sont reformées en exposant successivement un seul flanc des deuxièmes couches (20), et dans lequel le dépôt de la couche (40) à base du matériau semi-métallique forme un seul contact (40S, 40D) parmi les contacts (40S, 40D) de source et de drain.

13. Procédé de fabrication selon la revendication précédente, dans lequel l'autre contact parmi les contacts de source et de drain est un contact métallique (45D) formé par dépôt d'une couche métallique dans une partie des deuxièmes ouvertures (200c).

14. Procédé de fabrication selon la revendication précédente, dans lequel le dépôt de la couche (40) à base du matériau semi-métallique est effectué par croissance à partir de zones exposées dudit contact métallique (45D) au travers des deuxièmes espaces (31).

15. Procédé de fabrication selon l'une quelconque des revendications 8 à 14, dans lequel les deuxièmes ouvertures (200b) présentent une section constante le long de la direction verticale (z), ladite section étant prise dans un plan (xy) perpendiculaire à la direction verticale (z).
